(19) Europäisches Patentamt
European Patent Office
Office européen des brevets

(11) EP 0 831 372 A1

# (12) EUROPÄISCHE PATENTANMELDUNG

(43) Veröffentlichungstag:
**25.03.1998 Patentblatt 1998/13**

(51) Int. Cl.$^6$: **G03F 7/027**

(21) Anmeldenummer: **97115839.9**

(22) Anmeldetag: **11.09.1997**

(84) Benannte Vertragsstaaten:
**AT BE CH DE DK ES FI FR GB GR IE IT LI LU MC NL PT SE**

(30) Priorität: **23.09.1996 DE 19638988**

(71) Anmelder:
**SIEMENS AKTIENGESELLSCHAFT**
**80333 München (DE)**

(72) Erfinder:
- **Rogler, Wolfgang, Dr.**
  **91096 Möhrendorf (DE)**
- **Schön, Lothar, Dipl.-Ing.**
  **91077 Neunkirchen (DE)**
- **Muhrer, Volker, Dipl.-Ing.**
  **90768 Fürth (DE)**
- **Bayer, Heiner, Dr.**
  **82140 Olching (DE)**
- **Fischer, Walter, Dipl.-Ing.**
  **83026 Rosenheim (DE)**

## (54) Photopolymere

(57) Photopolymere, die für die Stereolithographie geeignet sind, weisen folgende Zusammensetzung auf:

- 60 bis 95 % eines Dimethacrylats der Struktur

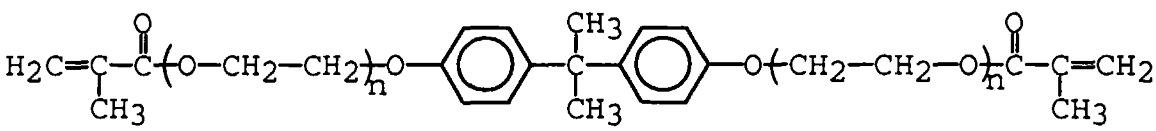

mit n = 3 bis 8,
- 0,1 bis 10 % wenigstens eines radikalbildenden Photoinitiators,
- 0 bis 30 % eines di- und/oder trifunktionellen Urethanacrylats mit einer Molmasse ≥ 1000 g/mol, und
- 0 bis 10 % Additive.

EP 0 831 372 A1

**Beschreibung**

Die Erfindung betrifft Photopolymere auf Methacrylatbasis, insbesondere zur Herstellung maßgenauer dreidimensionaler Kunststoffteile mittels Stereolithographie.

Die wichtigste Technologie beim sogenannten Rapid Prototyping Engineering (RPE) ist die Stereolithographie. Hierbei werden Kunststoff-Prototypen schichtweise hergestellt, indem ein rechnergesteuerter Laserstrahl die Oberfläche eines flüssigen, mittels Laserschicht härtbaren Photopolymers bildmäßig belichtet und so eine erste Teilschicht des herzustellenden dreidimensionalen Gebildes aushärtet. Diese (teil-)gehärtete Schicht wird dann beispielsweise in ein Photopolymerbad abgesenkt, mit frischem Photopolymer beschichtet und erneut bildmäßig mit dem Laser belichtet. Hierbei entsteht eine zweite gehärtete Teilschicht des dreidimensionalen Gebildes, die sich mit der ersten verbindet. Dieser Prozeß wird fortgesetzt, bis das gesamte Gebilde hergestellt ist, das dabei in das Photopolymerbad hineinwächst. Das auf diese Weise gebildete, nur teilweise ausgehartete „Grünteil" wird anschließend durch eine längere Belichtung mit UVA-Licht weitgehend ausgehärtet.

Zur stereolithographischen Herstellung von Musterbauteilen sind - wegen ihrer hohen Reaktivität - photohärtbare Reaktionsharze auf Acrylat- bzw. Methacrylatbasis prinzipiell geeignet. Sie erfüllen aber nicht alle wesentlichen Anforderungen an Photopolymere für die Stereolithographie (siehe dazu beispielsweise: R.W. Pfeiffer in „Proceedings of the 1st European Conference on Rapid Prototyping", 1992, Seiten 119 bis 132):

- Hohe Reaktivität, die eine Verfestigung der gewählten Schichtdicke bei minimaler Expositionsenergie, d.h. eine hohe Verfahrgeschwindigkeit des Lasers ermöglicht und damit ausschlaggebend ist für kurze und deshalb ökonomische Herstellungszeiten.
- Hohe Grünteilfestigkeit, d.h. ausreichende mechanische Festigkeit des im Photopolymerbad entstehenden, nur teilgehärteten Bauteils. Dies ist für einen maßgenauen Herstellungsprozeß und ein zerstörungsfreies Handling erforderlich, bis das Bauteil nachgehärtet ist und seine Endeigenschaften erreicht hat.
- Minimaler Schwund während der Härtung, was minimalen Curl während des Herstellungsprozesses und damit optimale Maßgenauigkeit bedeutet. Ausschlaggebend für geringen Curl ist der lineare Schwund in horizontaler Richtung, da aufgrund des schichtweisen Herstellungsprozesses immer eine teilgehärtete Schicht mit einer sich neu bildenden, ca. 100 μm dünnen Schicht verknüpft wird. Durch den Reaktionsschwund der neu generierten Schicht wird eine Spannung auf die darunter liegenden teilgehärteten Schichten ausgeübt, die zu Verzügen bzw. zu den bekannten Curl-Erscheinungen führt.
- Gute mechanische Eigenschaften der ausgehärteten Teile, die Funktionsprüfungen an den Bauteilen sowie die in der RPE-Technologie üblichen Folgeprozesse ermöglichen.
- Niedrige Viskosität von < 3000 mPa.s bei 25°C, bevorzugt < 1500 mPa • s, was eine Voraussetzung für ein optimales Recoating ist, d.h. für kurze Wartezeiten bis zur Planarisierung der Photopolymerschichten nach dem Schichterzeugungsprozeß.

Aufgrund dieses komplexen Aßforderungsspektrums an Photopolymere für die Stereolithographie sind die meisten bekannten Harzformulierungen aus vielen Mischungskomponenten zusammengesetzt, wie sich aus folgenden Beispielen ergibt:

- In der EP-OS 0 425 441 sind für die Stereolithographie geeignete Formulierungen beschrieben, die aus 5 bis 25 % eines monomeren aliphatischen oder cycloaliphatischen Di(meth)acrylats, 0 bis 15 % eines monomeren Poly(meth)acrylats mit einer Funktionalität von mindestens 3, 0 bis 20 % eines Mono(meth)acrylats oder einer Mono-N-vinylverbindung, 20 bis 60 % eines Urethan(meth)acrylats mit einer Funktionalität von 2 bis 4, 10 bis 50 % eines monomeren oder oligomeren Di(meth)acrylats auf Basis von Bisphenol A oder F, 0,1 bis 10 % eines Photoinitiators und 0 bis 5 % üblichen Additiven bestehen.
- Aus der EP-OS 0 517 657 sind Photopolymermischungen aus 5 bis 95 % photoreaktiven Polyestern, 10 bis 90 % polyfunktionellem (Meth)acrylat, 0 bis 70 % Mono(meth)acrylat und 0 bis 10 % Additiven bekannt.
- WO 89/08021 betrifft die Verwendung von Photopolymeren für stereolithographische Prozesse, die aus 20 bis 80 % harzartigem Poly(meth)acrylat, 80 bis 20 % flüssigem Poly(meth)acrylat und 10 bis 40 % eines Vinylmonomeren bestehen.
- In der EP-OS 0 525 578 sind Photopolymermischungen, die aus 25 bis 65 % difunktionellem Urethanacrylat, 15 bis 65 % Polyethylenglycoldi(meth)acrylat und 0 bis 30 % polyfunktionellem Reaktivverdünner bestehen, sowie deren Verwendung zur Herstellung dreidimensionaler Körper beschrieben.
- Aus der EP-OS 0 378 144 sind Photopolymere bekannt, die aus 5 bis 25 % tri-, tetra- oder pentafunktionellen (Meth)acrylaten, 1 bis 25 % Monoacrylaten und 10 bis 80 % Di(meth)acrylaten folgender Struktur

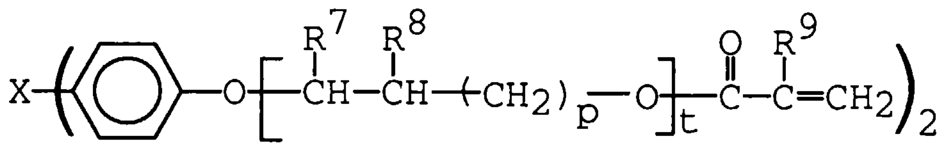

aufgebaut sind, wobei folgendes gilt:

p = 0 oder 1;
t = 0 oder 1 sowie 2 oder 3, wenn p = 0;
X = O, S, $SO_2$ oder $R^{10}$-C-$R^{11}$,
mit $R^{10}$ und $R^{11}$ = H, $CH_3$ oder $CF_3$;
$R^7$ = H oder $CH_3$, wenn p = 0, und H, wenn p = 1;
$R^8$ = H, wenn p = 0, und OH, wenn p = 1;
$R^9$ = H oder $CH_3$.

Verbindungen dieser Art können entweder durch Umsetzung von Bisphenol-A-diglycidylethern mit (Meth)acrylsäure oder durch Veresterung des entsprechenden Diols mit (Meth)acrylsäure hergestellt werden.
Im ersten Fall werden (Meth)acrylsäureester mit freien OH-Gruppen und Oligomeranteilen erhalten. Dies führt zu einer unerwünscht hohen Viskosität, was bei Stereolithographieanwendungen durch Zugabe niedrigviskoser mono- oder polyfunktioneller Reaktivverdünner ausgeglichen werden muß. Derartige Verbindungen besitzen aber im allgemeinen einen erhöhten Dampfdruck und damit eine erhöhte Flüchtigkeit. Da sich bei der Stereolithographie die Photopolymere bei leicht erhöhter Temperatur in einem offenen Behälter befinden, besteht deshalb einerseits die Gefahr, daß sich die Zusammensetzung - und damit die Verarbeitungs- und Bauteileigenschaften - im Laufe der Zeit unkontrolliert verändern, und andererseits bedeuten derartige flüchtige Komponenten eine erhöhte Gesundheitsgefährdung für das Bedienungspersonal, beispielsweise bei 1-Vinyl-2-pyrrolidinon. Nachteilig wirkt sich ferner aus, daß monofunktionelle Verbindungen der genannten Art die im Stereolithographieprozeß gebildeten Strukturen, die nur teilweise gehärtet sind, leicht anquellen können, wodurch sich Verformungen und Maßabweichungen ergeben.
Im zweiten Fall der vorstehend genannten Umsetzung erhält man OH-gruppenfreie (Meth)acrylsäurediester, die je nach dem ob p den Wert 1,2 oder 3 hat, einen ein- bis dreifach alkoxylierten Bisphenol-A-Grundkörper enthalten.

Mit den vorstehend beschriebenen Photopolymeren auf (Meth)acrylatbasis lassen sich zwar stereolithographisch dreidimensionale Kunststoffkörper herstellen, diese erfüllen die genannten Anforderungen jedoch nicht in zufriedenstellender Weise. Vor allem ein zu hoher Schwund führt bei der Härtung zum bekannten Curling und damit zu einer schlechten, nicht tolerierbaren Maßgenauigkeit. Wie bereits erwähnt, ist für das Curling vor allem der lineare Schwund maßgebend. Jede neu gebildete Polymerschicht führt dabei - durch schwundverursachte Spannungen auf darunter liegende Schichten - zu den charakteristischen Verzügen.

Handelsübliche Stereolithographie-Photopolymere haben einen linearen Schwund von ca. 2 bis 2,5 %. Dieser Schwund kann beispielsweise in der Weise bestimmt werden, daß das flüssige Photopolymer in nach oben offene Aluminiumformen mit einer Tiefe von 1 mm eingefüllt und durch UV-Bestrahlung mit handelsüblichen Flächenstrahlern ausgehärtet wird. Der lineare Schwund ergibt sich dann aus der Differenz zwischen der Soll-Länge und der tatsächlichen Länge der gehärteten Probestreifen. Darüber hinaus ergeben Formulierungen der genannten Art relativ spröde Formstoffe, die in der Regel nur als Anschauungsobjekte verwendet werden können, nicht funktional prüfbar und für Folgeprozesse des Rapid Prototyping, wie Abformen, nur bedingt geeignet sind.

Vor allem in der Elektrotechnik und Elektronik werden außerdem die Bauteile zunehmend kompakter. Die bisher nicht befriedigende Maßhaltigkeit hat hier bislang einen breiteren Einsatz der Stereolithographie bei der Entwicklung neuer Kunststoffteile verhindert.

Aufgabe der Erfindung ist es, Photopolymere bereitzustellen, die - infolge eines deutlich geringeren Reaktionsschwundes - die Herstellung von Kunststoffteilen mit verbesserter Maßhaltigkeit erlauben, welche aufgrund besserer mechanischer Eigenschaften funktional prüfbar sind.

Dies wird erfindungsgemäß durch Photopolymere folgender Zusammensetzung erreicht:

- 60 bis 95 % eines Dimethacrylats der Struktur

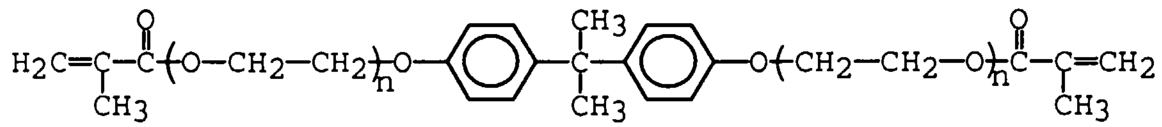

mit n = 3 bis 8,

- 0,1 bis 10 % wenigstens eines radikalbildenden Photoinitiators,
- 0 bis 30 % eines di- und/oder trifunktionellen Urethanacrylats mit einer Molmasse ≥ 1000 g/mol, und
- 0 bis 10 % Additive,

wobei sich die Anteile der einzelnen Komponenten zu 100 Masse-% ergänzen.

Bei umfangreichen Untersuchungen des Schwundverhaltens vieler Acrylat- und Methacrylatverbindungen hat sich nämlich überraschenderweise gezeigt, daß Methacrylsäureester von alkoxyliertem Bisphenol A der vorstehenden Struktur bei der Laserhärtung zu Formstoffen mit vergleichsweise sehr geringem Schwund führen. Dabei wurde gefunden, daß ein optimaler Bereich der Methacrylatkonzentration von etwa 1,9 mol/kg bis etwa 3,2 mol/kg existiert, entsprechend einem Alkoxylierungsgrad n von 3 bis 8.

Bei einer höheren Methacrylatkonzentration werden die Methacrylatgruppen nicht vollständig ausgehärtet, was sich nachteilig auf die Langzeiteigenschaften auswirkt, da bei Tageslicht über längere Zeit unkontrollierte Nachhärteeffekte mit Veränderungen bei den Abmessungen auftreten können. Bei einer zu geringen Methacrylatkonzentration andererseits werden lediglich weiche, gummiartige Formstoffe erhalten, die nicht die Festigkeit aufweisen, welche für Modelle von Kunststoffteilen gefordert wird.

Außerdem wurde überraschenderweise gefunden, daß bereits Methacrylsäureester von alkoxyliertem Bisphenol A der vorstehenden Struktur allein - zusammen mit Photoinitiatoren - zu Photopolymeren führen, die schwundarme, mechanisch ausgezeichnete Formstoffe ergeben. Ferner ist folgendes von Bedeutung. Dem Fachmann ist an sich bekannt, daß Methacrylate gegenüber Acrylaten eine deutlich geringere Polymerisationsgeschwindigkeit aufweisen. Überraschenderweise hat sich aber gezeigt, daß bei methacrylatfunktionellen Verbindungen der vorstehend genannten Art die bei der Stereolithographie zur Charakterisierung der Reaktivität üblichen Kenngrößen - kritische Energie („Critical Exposure") Ec und Eindringtiefe („Penetration Depth") Dp (siehe dazu: H. Nguyen, J. Richter, P.F. Jacobs in „Proceedings of the 1st European Conference on Rapid Prototyping", 1992, Seiten 133 bis 161) - ähnliche Werte erreichen wie vergleichbare acrylatfunktionelle Verbindungen. Die Optimierung der Formstoffeigenschaften erfolgt im übrigen mit Methacrylatmischungen mit einer Molekulargewichtsverteilung, die im Rahmen einer Methacrylatkonzentration von 1,9 bis 3,2 mol/kg liegt. Die Herstellung der Methacrylate erfolgt in der Weise, daß Bisphenol A mit Ethylenoxid umgesetzt und das dabei entstandene Diol - unter bekannten Bedingungen - mit Methacrylsäure verestert wird.

Zur Einstellung einer ausreichenden Photosensibilität werden den Dimethacrylaten 0,1 bis 10 % wenigstens eines radikalbildenden Photoinitiators zugesetzt. Der Photoinitiator wird dabei so ausgewählt, daß er für die im Stereolithographieprozeß verwendeten Laser geeignet ist, deren Wellenlänge üblicherweise im UV-Bereich liegt. Dies bedeutet, daß der Photoinitiator bei der Laserwellenlänge Licht absorbiert und Radikale bildet. Die Konzentration des Photoinitiators wird so eingestellt, daß die im Stereolithographieprozeß gewählte Schichtdicke mit üblichen Laserverfahrgeschwindigkeiten gehärtet werden kann. Für Schichtdicken von beispielsweise 0,1 bis 0,2 mm wird die Konzentration so gewählt, daß sich eine Eindringtiefe im Bereich von 0,05 bis 0,3 mm ergibt.

Prinzipiell verwendbare Photoinitiatoren sind Verbindungen wie Benzoin, Benzoinether, Benzil, Benzilketale, Acetophenone und Acylphosphinoxide, die gemäß Norrish-Typ I reagieren, sowie Verbindungen wie Benzophenone, Thioxanthone und Campherchinon, die gemäß Norrish-Typ II Radikale bilden (siehe dazu: Leonard J. Calbo „Handbook of Coatings Additives", Vol. 2, Seiten 1 bis 43, Marcel Dekker Inc., 1992). Die Photopolymeren nach der Erfindung können auch Mischungen verschiedener Photoinitiatoren enthalten.

Als Laser dienen die üblicherweise in Stereolithographieprozessen eingesetzten Laser, wie Argonionenlaser, HeCd-Laser und frequenzvervielfachte Festkörperlaser. Dabei werden bevorzugt folgende Photoinitiatoren eingesetzt: Bei der Härtung mit einem HeCd-Laser (325 nm) 1-Hydroxycyclohexylphenylketon und bei der Härtung mit einem Argonionenlaser (351/364 nm) Benzildimethylketal, 2,4,6-Trimethylbenzoyldiphenylphosphinoxid oder 2-Benzyl-2-N,N-dimethylamino-1-(4-morpholinophenyl)-butanon. Den Photopolymeren nach der Erfindung können bis zu 10 % von für Photopolymere üblichen Additiven, wie Sensibilisatoren, Photoaktivatoren und Zusätze zur Modifizierung der Oberflächenspannung, des Benetzungs- und Entgasungsverhaltens, zugesetzt werden.

Zur weiteren Verbesserung der mechanischen Eigenschaften der stereolithographisch hergestellten Formkörper können den Methacrylsäureestern bis zu 30 % Urethanacrylate mit einer Molmasse ≥ 1000 g/mol und einer Funktionalität von 2 bis 3 zugesetzt werden. Derartige Verbindungen sind an sich bekannt. Sie können in üblicher Weise hergestellt werden, indem beispielsweise di- oder trifunktionelle Alkohole mit Diisocyanaten umgesetzt werden, wobei das Verhältnis von Isocyanatgruppen zu Hydroxylgruppen mindestens 2:1 beträgt. Das entstandene Di- bzw. Triisocyanat wird dann durch Reaktion mit einem hydroxyfunktionellen Acrylat zum gewünschten Urethanacrylat funktionalisiert. Durch geeignete Wahl des Molverhältnisses von Isocyanatgruppen zu Hydroxylgruppen kann die angestrebte Molmasse eingestellt werden. Als Alkohole können Polyether-, Polyester- und Polyalkylenpolyole oder hydroxylgruppenterminierte Polyurethane eingesetzt werden. Geeignete Diisocyanate sind beispielsweise Toluylendiisocyanat, Hexamethylendiisocyanat, Isophorondiisocyanat und Diphenylmethandiisocyanat. Bevorzugt sind Urethanacrylate auf der Basis Polyesterpolyol und Toluylendiisocyanat. Eine weitere Möglichkeit zur Herstellung der Urethanacrylate besteht in der Umsetzung von oligomeren isocyanatfunktionellen Verbindungen mit hydroxyfunktionellen Acrylaten. Die Molmasse der Urethanacrylate liegt vorzugsweise unter 5000 g/mol. Bei höheren Molmassen ist zunehmend eine starke Erhöhung der Viskosität der Mischung sowie eine Absenkung der Glasübergangstemperatur zu beobachten.

Anhand von Ausführungsbeispielen soll die Erfindung noch näher erläutert werden.

Zur Aufbereitung der nachfolgend beschriebenen Mischungen wird die (Meth)acrylatkomponente in einem geeigneten Rührgefäß vorgelegt und die entsprechende Menge an Photoinitiator zugewogen; anschließend wird bei Raumtemperatur bis zur vollständigen Auflösung des Photoinitiators gerührt. Vor der Untersuchung bzw. Verarbeitung der dabei erhaltenen Harzmischung wird so lange gewartet, bis eingerührte Blasen vollständig aufgestiegen und geplatzt sind. Die Aufbereitung erfolgt unter Ausschluß von UV-Licht.

Beispiele 1 bis 6

Es werden Photopolymere eingesetzt, die jeweils aus einem ethoxylierten Bisphenol-A-diacrylat bzw. -dimethacrylat folgender Struktur

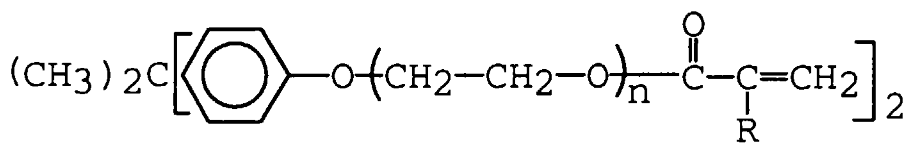

und 3,5 Masseteilen Benzildimethylketal als Photoinitiator bestehen.

Tabelle 1

| Beispiel | 1 | 2 | 3 | 4 | 5 | 6 |
|---|---|---|---|---|---|---|
| Reaktive Gruppe | Acrylat | Acrylat | Acrylat | Methacrylat | Methacrylat | Methacrylat |
| R | H | H | H | $CH_3$ | $CH_3$ | $CH_3$ |
| Doppelbindungsgehalt (mol/kg) | 3,89 | 3,53 | 2,72 | 3,85 | 3,15 | 1,95 |
| n (errechnet aus Doppelbindungsgehalt) | 2,0 | 2,6 | 4,5 | 1,8 | 3,1 | 7,5 |
| Glasübergangstemperatur (°C) [1)] | 90 | 62 | 16 | 149 | 92 | 55 |
| Volumenschwund (%) [2)] | 5,7 | 5,9 | 5,0 | 5,9 | 5,8 | 3,6 |
| Linearer Schwund in x- und y-Richtung (%) [3)] | 2,1 | 2,1 | 2,3 | 1,2 | 0,9 | 0,7 |
| Umsatz [4)] | 87 % | 93 % | 100 % | 70 % | 97 % | 98 % |
| Kritische Energie Ec (mJ/cm$^2$) [5)] | 3,6 | 3,0 | 3,0 | 4,5 | 3,8 | 3,7 |
| Eindringtiefe Dp (mm) [5)] | 0,19 | 0,17 | 0,16 | 0,18 | 0,16 | 0,16 |

[1)] Die Glasübergangstemperatur, definiert als das Maximum des mechanischen Verlustfaktors $\tan \delta$, wird durch dynamischmechanische Messung bei 1 Hz und einer Heizrate von 5 K/min ermittelt; Probekörper: 1 mm dick, gehartet durch UV-Bestrahlung der flüssigen Mischung mit einem Quecksilber-Mitteldruckstrahler bei einer UV-Dosis von 15 J/cm$^2$.

[2)] Der Volumenschwund wird aus dem Dichteunterschied zwischen dem flüssigen Photopolymer und dem gehärteten Formstoff errechnet.

[3)] Das flüssige Photopolymer wird in eine 1 mm tiefe, oben offene Aluminiumform von 10 cm Länge gegossen und darin durch UV-Bestrahlung mit einem Quecksilber-Mitteldruckstrahler bei einer UV-Dosis von 15 J/cm$^2$ ausgehärtet; als linearer Schwund wird die Differenz zwischen der Soll-Länge und der tatsächlichen Länge des Probestreifens ausgewertet.

[4)] Der erreichbare Umsatz an funktionellen Gruppen wird aus Photo-DSC-Untersuchungen ermittelt: gemessene Reaktionsenthalpie im Verhältnis zur Standardreaktionsenthalpie für Acrylate von 19,2 kcal/mol und für Methacrylate von 13,6 kcal/mol (siehe dazu: S. Peter Pappas „Radiation Curing - Science and Technologie", Seite 61, Plenum Press New York and London, 1992).

[5)] Mit einem fokussierten Argonionenlaser (Leistung: ca. 60 mW) werden auf die Photopolymeroberfläche parallele, überlappende Linien geschrieben und auf diese Weise einzelne Schichten gehärtet. Durch Variation von Lasergeschwindigkeit und Linienabstand wird die UV-Dosis abgeändert, wobei unterschiedlich dicke Schichten erhalten werden. Die Kenngrößen Ec und Dp werden in an sich bekannter Weise ermittelt (siehe: R.W. Pfeiffer, a.a.Q.).

Die Beispiele 4 bis 6 zeigen, daß die methacrylatfunktionellen Verbindungen ein in x- und y-Richtung minimiertes Schwundverhalten aufweisen, was - wie bereits ausgeführt - bei einem Schichterzeugungsprozeß, wie bei der Stereolithographie, besonders vorteilhaft ist. Acrylate verhalten sich demgegenüber mit etwa verdoppeltem Schwund deutlich ungünstiger (siehe die Beispiele 1 bis 3).

Weiterhin zeigt sich, daß zur Erreichung eines vollständigen Umsatzes und eines reduzierten Volumenschwundes ein möglichst geringer Doppelbindungsgehalt vorteilhaft ist. Dieser Effekt macht sich bei den Acrylaten (Beispiele 1 bis 3) aber erst ab einem Doppelbindungsgehalt < 3,5 mol/kg bemerkbar, gekoppelt mit einem deutlichen Rückgang der Glasübergangstemperatur auf 16°C. Damit verbunden ist ein ungenügender E-Modul und mangelnde Festigkeit der entstehenden Formstoffe, wodurch ein technischer Einsatz verhindert wird. Bei Methacrylaten (siehe Beispiele 5 und 6) zeigt sich dagegen, daß bei einem Doppelbindungsgehalt unter ca. 3,2 mol/kg ein minimiertes Schwundverhalten kombiniert ist mit einer ausreichend hohen Glasübergangstemperatur und einem ausreichend hohen Umsatz an funktionellen Gruppen. Bei einem höheren Doppelbindungsgehalt (siehe Beispiel 4), entsprechend einem geringeren Ethoxylierungsgrad, werden - wegen einer zu hohen Glasübergangstemperatur - nur unvollständig ausgehärtete Formstoffe erhalten.

Beispiele 7 bis 12

Diese Beispiele zeigen, daß sich die mechanischen Eigenschaften stereolithographisch hergestellter Formstoffe durch den Zusatz von bis zu 30 % spezieller Urethanacrylate verbessern lassen; Schwundverhalten und Verarbeitungseigenschaften werden dabei nicht negativ beeinflußt. Die Probekörper zur Bestimmung der mechanischen Eigenschaften werden auf einer Stereolithographieanlage mit Ar-Ionen-Laser (Wellenlänge: 351 und 364 nm) bei einer

Laserleistung von 50 mW hergestellt; die Dicke der einzelnen Schichten beträgt 0,1 mm. Die Verfahrgeschwindigkeit des Lasers und der Linienabstand werden so gewählt, daß eine Einhärtetiefe („Cure depth") Cd von 0,3 mm erreicht wird. Die erhaltenen „Grünteile" werden mit UVA-Leuchtstoffröhren 24 h nachbelichtet.

Tabelle 2

| Beispiel | 7 | 8 | 9 | 10 | 11 | 12 |
|---|---|---|---|---|---|---|
| Zusammensetzung (Masseteile) | | | | | | |
| Ethoxyliertes Bisphenol-A-dimethacrylat (3,15 mol/kg Doppelbindungen) | 89 | 86,5 | 85,1 | 76,5 | 71,5 | 66,5 |
| Trifunktionelles Polyesterurethanacrylat (Molmasse: 1200) | 7,5 | 10 | 15 | 20 | 25 | 30 |
| Benzildimethylketal | 3,5 | 3,5 | 3,5 | 3,5 | 3,0 | 3,0 |
| Verarbeitungseigenschaften | | | | | | |
| Ec ($mJ/cm^2$) 5) | 4,05 | 4,03 | 4,06 | 4,9 | 3,33 | 3,27 |
| Dp (mm) 5) | 0,14 | 0,15 | 0,15 | 0,14 | 0,17 | 0,18 |
| Viskosität bei 25°C (mPa.s) | 850 | 1020 | 1180 | 1490 | 2200 | 2800 |
| Formstoffeigenschaften | | | | | | |
| E-Modul ($N/mm^2$) | 1681 | 1870 | 1536 | 1562 | 1315 | 1372 |
| Reißdehnung (%) | 5,0 | 5,7 | 8,7 | 8,7 | 10,7 | 10,9 |
| Zugfestigkeit ($N/mm^2$) | 43 | 44 | 39 | 39 | 36 | 35 |
| Schlagzähigkeit ($kJ/m^2$) (Izod - ISO 180)) | 23 | 29 | 31 | 35 | 38 | 43 |
| Linearer Schwund in x- und y-Richtung (%) 3) | 1,04 | 1,02 | 1,24 | 1,21 | 1,27 | 1,37 |
| Zu den Anmerkungen 3) und 5) siehe Tabelle 1 | | | | | | |

Beispiele 13 bis 18

Die Formstoffeigenschaften der nachfolgend beschriebenen Mischungen sind an polychromatisch flächig belichteten Probekörpern ermittelt. Dazu wird die flüssige Photopolymermischung in eine Aluminiumform der entsprechenden Geometrie gegossen und mit einem Quecksilber-Mitteldruckstrahler mit einer UV-Dosis von 15 $J/cm^2$ belichtet.

Tabelle 3

| Beispiel | 13 | 14 | 15 | 16 | 17 | 18 |
|---|---|---|---|---|---|---|
| Zusammensetzung (Masseteile) | | | | | | |
| Ethoxyliertes Bisphenol-A-dimethacrylat (Methacrylatgehalt: 3,15 mol/kg) | 96,5 | 86,5 | 86,5 | 76,5 | 76,5 | 86,5 |
| Trifunktionelles Polyesterurethanacrylat (Molmasse: 1200) | - | 10 | - | 10 | 10 | - |
| Difunktionelles Polyesterurethanacrylat (Molmasse: 900) | - | - | 10 | - | - | - |
| Difunktionelles aliphatisches Urethanacrylat (Molmasse: 1500) | - | - | - | - | - | 10 |
| Hexafunktionelles aromatisches Urethanacrylat (Molmasse: 1000) | - | - | - | 10 | - | - |
| Hexafunktionelles aliphatisches Urethanacrylat (Molmasse: 800) | - | - | - | - | 10 | - |
| Benzildimethylketal | 3,5 | 3,5 | 3,5 | 3,5 | 3,5 | 3,5 |
| Verarbeitungseigenschaften | | | | | | |
| Ec ($mJ/cm^2$) [5] | 4,6 | 4,03 | 4,0 | 4,0 | 4,3 | 5,1 |
| Dp (mm) [5] | 0,15 | 0,15 | 0,17 | 0,17 | 0,18 | 0,16 |
| Viskosität bei 25°C (mPa.s) | 640 | 1020 | 960 | 1390 | 1440 | 970 |
| Formstoffeigenschaften | | | | | | |
| Glasübergangstemperatur (°C) [1] | 104 | 65 | 95 | 104 | 91 | 103 |
| E-Modul ($N/mm^2$) | 2825 | 2745 | 2650 | 2900 | 2830 | 1948 |
| Reißdehnung (%) | 5,7 | 8,7 | 5,7 | 4,4 | 3,6 | 9,0 |
| Zugfestigkeit ($N/mm^2$) | 63 | 59 | 56 | 62 | 59 | 41,6 |
| Schlagzähigkeit ($kJ/m^2$) (Charpy, ungekerbt -DIN 53453) | 16 | 32 | 17 | 13 | 14 | 16 |
| Zu den Anmerkungen [1] und [5] siehe Tabelle 1 | | | | | | |

Durch diese Beispiele wird deutlich, daß die mechanischen Eigenschaften des reinen ethoxylierten Bisphenol-A-dimethacrylats (siehe Beispiel 13) insbesondere durch di- und trifunktionelle Urethanacrylate mit einer Molmasse von ≥ 1000 g/mol (Beispiele 14 und 18) entscheidend verbessert werden können, wahrend demgegenüber höherfunktionelle Urethanacrylate (Beispiele 16 und 17) sowie kürzerkettige Urethanacrylate (Beispiel 15) wirkungslos sind oder sogar zu einer Verschlechterung führen, insbesondere zu einer verringerten Reißdehnung.

**Patentansprüche**

1. Photopolymere auf Methacrylatbasis, insbesondere für die Stereolithographie, **gekennzeichnet** durch folgende Zusammensetzung:

   - 60 bis 95 % eines Dimethacrylats der Struktur

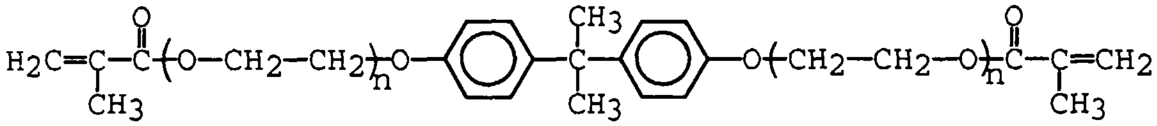

   mit n = 3 bis 8,
   - 0,1 bis 10 % wenigstens eines radikalbildenden Photoinitiators,
   - 0 bis 30 % eines di- und/oder trifunktionellen Urethanacrylats mit einer Molmasse ≥ 1000 g/mol, und

- 0 bis 10 % Additive,

wobei sich die Anteile der einzelnen Komponenten zu 100 Masse-% ergänzen.

2. Photopolymere nach Anspruch 1, **dadurch gekennzeichnet,** daß das Dimethacrylat einen Methacrylatgehalt von 1,9 bis 3,2 mol/kg aufweist.

3. Photopolymere nach Anspruch 1 oder 2, **dadurch gekennzeichnet,** daß die Molmasse des Urethanacrylats 1000 bis 5000 g/mol beträgt.

4. Photopolymere nach einem der Ansprüche 1 bis 3, **dadurch gekennzeichnet,** daß der Photoinitiator 1-Hydroxycyclohexylphenylketon, Benzildimethylketal, 2,4,6-Trimethylbenzoyldiphenylphosphinoxid oder 2-Benzyl-2-N,N-dimethylamino-1-(4-morpholinophenyl)-butanol ist.

5. Verwendung der Photopolymere nach einem oder mehreren der Ansprüche 1 bis 4 zur Herstellung von Formkörpern mittels Stereolithographie.

Europäisches Patentamt

# EUROPÄISCHER RECHERCHENBERICHT

Nummer der Anmeldung
EP 97 11 5839

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | WO 96 28763 A (ZENECA LTD ;POPAT AJAY HARIDAS (GB); LAWSON JOHN ROBERT (GB)) * Beispiele 1-6 * * das ganze Dokument * --- | 1-5 | G03F7/027 |
| A | PATENT ABSTRACTS OF JAPAN vol. 007, no. 070 (P-185), 23.März 1983 & JP 58 001142 A (HITACHI KASEI KOGYO KK), 6.Januar 1983, * Zusammenfassung * --- | 1-5 | |
| A | EP 0 674 225 A (HITACHI CHEMICAL CO LTD) * Anspruch 3 * * das ganze Dokument * --- | 1-5 | |
| A | EP 0 675 411 A (HITACHI CHEMICAL CO LTD) * Anspruch 4 * * das ganze Dokument * --- | 1-5 | |
| A | DE 32 42 800 A (HITACHI CHEMICAL CO LTD) * Beispiel 1 * * das ganze Dokument * ----- | 1-5 | RECHERCHIERTE SACHGEBIETE (Int.Cl.6): G03F |

Der vorliegende Recherchenbericht wurde für alle Patentansprüche erstellt

| Recherchenort | Abschlußdatum der Recherche | Prüfer |
|---|---|---|
| DEN HAAG | 18.Dezember 1997 | Martins Lopes, L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)